# FASCICULE DE BREVET EUROPEEN

(11) **EP 0 683 563 B1**
(45) Date de publication et mention de la délivrance du brevet: **05.01.2000**
(21) Numéro de dépôt: 95201236.7
(22) Date de dépôt: 12.05.1995
(51) Int. Cl.: H03J 1/00

(54) **Commande pour un appareil de télévision, programmable par l'utilisateur**
Bedienung für ein durch den Benutzer programmierbares Fernsehgerät
Control for a television set, programmable by the user

(30) Priorité: 18.05.1994 FR 9406073
(43) Date de publication de la demande: 22.11.1995
(73) Titulaire: PHILIPS ELECTRONIQUE GRAND PUBLIC, 92150 Suresnes (FR); Koninklijke Philips Electronics N.V., 5621 BA Eindhoven (NL)
(72) Inventeur: Cotty, Michel, Société Civile S.P.I.D., F-75008 Paris (FR)
(74) Mandataire: Charpail, François

(56) Documents cités:
- DE-A- 4 225 052
- DE-U- 9 318 890

## Description

La présente invention concerne un dispositif de commande pour un appareil audio ou vidéo, muni de moyens de saisie dits normaux permettant de réaliser au choix plusieurs types de réglages différents au moyen de séquences spécifiques de commandes aboutissant chacune au réglage d'une variable à régler déterminée, et muni d'une position de mémoire pour, un code de type étant défini pour chaque variable à régler identifiant de quel type de variable à régler il s'agit, enregistrer un de ces codes de type, et de moyens d'inscription, pour inscrire dans la dite position de mémoire le code de type d'une variable à régler.
Les moyens de saisie normaux mentionnés ci-dessus, mis à la disposition de l'utilisateur, consistent généralement en des touches d'un clavier, situées sur une télécommande infrarouge et/ou sur la façade de l'appareil. Il pourrait néanmoins aussi bien s'agir de plages sensitives pour une sélection sans contact, par exemple par toucher d'écran, ou d'une commande par la voix, ou de tout moyen de saisie connu, au niveau du téléviseur lui même ou au niveau d'un boîtier de télécommande. On considèrera par la suite seulement le cas de touches d'un boîtier de télécommande.

On prévoyait autrefois autant de paires de touches spécialisées qu'il y a de variables différentes à régler, toutefois ceci conduisait à un grand nombre de touches de commande. En outre, pour éviter une traduction en diverses langues, on utilisait pour le repérage des touches des symboles ou logos, qui sont d'autant plus difficilement mémorisables qu'ils sont plus nombreux.
C'est pour éviter cela que le système des menus a été inventé : il s'agit de menus arborescents apparaissant sur l'écran de l'appareil, qui ont étés introduits sur la plupart des appareils depuis la fin des années 1980. Ces menus peuvent être présentés en clair dans toutes les langues grâce à un simple logiciel. Néanmoins ce procédé présente un inconvénient lui aussi : un certain nombre de sélections est nécessaire avant d'atteindre la commande voulue, d'où une perte de temps pour l'utilisateur. C'est pourquoi on conserve parfois, en plus d'une commande par menus, des touches spécialisées pour certaines des commandes les plus habituelles. Il y a par exemple des touches spécialisées pour le réglage du son, parce qu'elles servent très souvent. Néanmoins, quand ces commandes spécialisées sont nombreuses, on se heurte à nouveau à l'inconvénient initial, et si elles sont peu nombreuses, il y a risque qu'elles ne soient justement pas celles souhaitées par l'utilisateur.
Une solution est de prévoir un nombre limité de touches spécialisées et de fournir à l'utilisateur des moyens pour affecter, selon ses désirs, un rôle donné à une touche donnée.
Un moyen de re-programmation d'une télécommande est connu du document EP-A- 0 446 864. Selon ce document, on apprend une nouvelle fonction à la télécommande à partir d'une seconde télécommande qui modifie la première en y inscrivant, dans une position de mémoire, un code de type d'une variable à régler.

Un but de l'invention est d'éviter le temps perdu avec le procédé des menus et d'éviter la présence de trop nombreuses touches, tout en étant économique et simple à utiliser. A cet effet le dispositif est muni de moyens pour activer automatiquement les dits moyens d'inscription à chaque fois qu'une variable à régler déterminée est réglée à l'issue de l'une des dites séquences spécifiques de commandes, pour inscrire le code de type de la variable qui est ainsi réglée, et d'au moins un moyen dit de saisie simplifiée permettant de réaliser, en association avec des moyens d'exécution, le réglage de la variable à régler dont le code est présent dans la dite position de mémoire.
L'invention est donc basée sur l'idée de donner aux touches de réglage "+" et "-" la fonction de réglage de la dernière variable qui a été réglée au moyen de la séquence de menus, tant que l'on ne passe pas à nouveau par cette séquence.

Selon une variante, le dispositif est muni de moyens dits d'affectation permettant de déclencher, lorsque l'utilisateur le désire lors de l'une des dites séquences spécifiques de commandes, l'inscription dans la dite position de mémoire du code de type de la variable qui est réglée, et d'au moins un moyen dit de saisie simplifiée, permettant de réaliser en association avec des moyens d'exécution le réglage de la variable à régler dont le code est présent dans la dite position de mémoire.
Ainsi l'utilisateur peut choisir le type de variable affectée aux moyens de saisie simplifiée.

Dans un mode de réalisation particulier, le dispositif est muni de moyens pour déclencher l'inscription dans la position de mémoire lorsque les dits moyens de saisie simplifiée sont utilisés.

Avantageusement, le dispositif comporte plusieurs moyens de saisie simplifiée, et autant de positions de mémoire d'un code de type, dont chacune correspond à un moyen de saisie simplifiée.
Ainsi des utilisateurs différents peuvent disposer chacun d'une commande simplifiée personnelle.

En outre le dispositif peut comporter au moins deux moyens de saisie simplifiée avec autant de positions de mémoire d'un code de type, l'un pour lequelle les moyens d'inscription sont activés automatiquement à chaque fois qu'une variable à régler déterminée a été réglée à l'issue de l'une des dites séquences spécifiques de commandes, et l'autre pour lequel des moyens dits d'affectation sont prévus, permettant de déclencher, seulement lorsqu'on le désire, après qu'une variable à régler déterminée a été réglée à l'issue de l'une des dites séquences spécifiques de commandes, l'inscription en mémoire du code de type de cette variable à régler déterminée.
Ainsi, pour un réglage ultérieur un utilisateur peut choisir entre deux types de réglages immédiatement utilisables :
celui qu'il a lui même déterminé antérieurement par les moyens d'affectation, et celui qui a été réalisé en dernier par le jeu des menus.

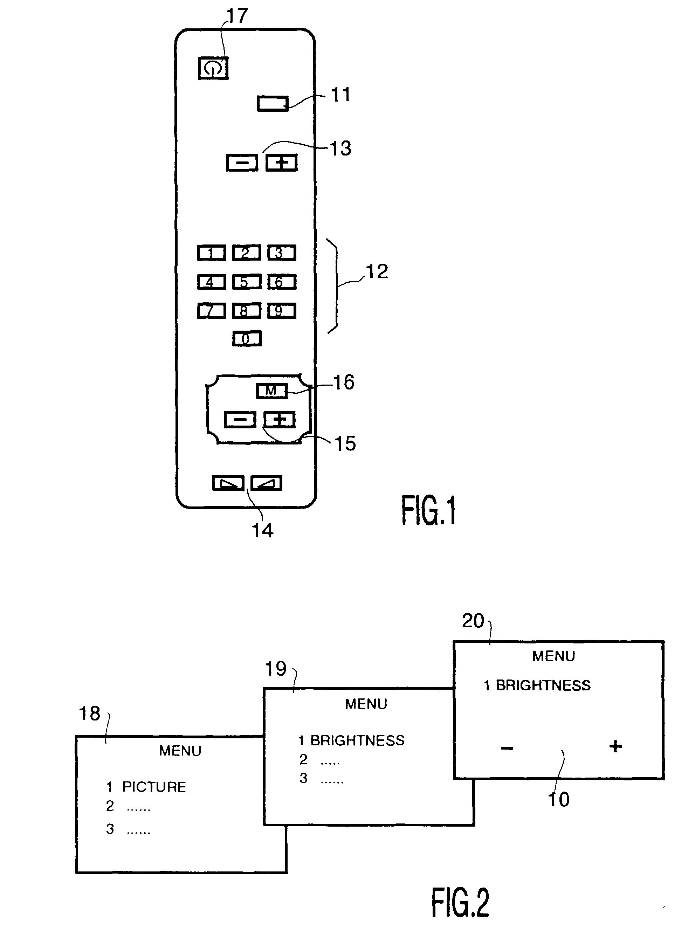

Ces aspects de l'invention ainsi que d'autres aspects plus détaillés apparaîtront plus clairement grâce à la description suivante d'un mode de réalisation non limitatif. La figure 1 représente un boîtier de télécommande de téléviseur, muni des moyens de l'invention.
La figure 2 représente l'aspect d'un écran de téléviseur dans trois états successifs correspondant à une séquence spécifique de commandes.

Le boîtier de télécommande de la figure 1 comporte notamment une touche de mise en veille 17, une touche 11 d'appel de menu, une paire de touches 14 de réglage de la puissance du son, et un pavé numérique 12 permettant le choix d'une option d'un menu (qui peut être le numéro d'une ligne du menu comme mentionné plus loin) et aussi la mise en route du téléviseur par appui sur la ou les touches correspondant au numéro de chaîne désiré.

Une paire 13 de touches porte des symboles "+" et "-". Elle permet de régler à peu près toutes les variables du téléviseur, par exemple : la luminance, le contraste, la saturation de couleur, le niveau des graves ou des aigus, ou le passage d'une chaîne à la suivante ou le retour à la précédente, dans l'ordre des numéros, etc.

Une procédure générale de commande peut consister par exemple en une séquence spécifique comprenant les étapes illustrées sur la figure 2. Une première pression sur la touche d'appel de menu 11 fait apparaître l'écran 18. Cet écran offre plusieurs possibilités de réglage dont une, qui porte le numéro 1, concerne l'image. Supposons que l'utilisateur la choisisse, en appuyant par exemple sur la touche "1" du pavé numérique, alors apparaît l'écran 19. Celui-ci offre à nouveau plusieurs possibilités de réglage dont une, qui porte le numéro 1, concerne la lumière. Supposons que l'utilisateur la choisisse, en appuyant à nouveau sur la touche "1", alors apparaît l'écran 20. Celui ci concerne uniquement la lumière, comme cela est souligné par un rectangle en surbrillance sur le mot "lumière", et permet d'augmenter ou de réduire celle-ci au moyen des touches 13 "+" et "-", ceci étant rappelé par le dessin des signes - et + en bas de l'écran. Ceci est fait en association avec des moyens d'exécution du réglage non représentés, car bien connus de l'homme du métier, utilisant par exemple une valeur de commande agissant sur un circuit intégré audio ou vidéo programmable. Une bande 10 apparaît aussi en bas de l'écran avec une longueur qui varie selon le réglage et visualise l'effet de celui-ci. On remarquera que pour arriver au réglage de la lumière, il a fallu passer successivement par trois menus. Le réglage du volume sonore n'est pas prévu dans un menu, parce que les touches 14 sont spécialisées pour ce réglage. Elles sont présentes en plus du procédé par menus, parce qu'elles servent très souvent.

Un code de type est défini pour chaque variable à régler, identifiant de quel type de variable à régler il s'agit. Il y a par exemple un code correspondant à la luminance, un autre au contraste, un autre à la saturation de couleur, un autre au niveau des graves, un autre au niveau des aigus, etc.

Le téléviseur est habituellement muni d'un processeur, en général un microprocesseur, pour gérer son fonctionnement. A ce microprocesseur est associée une mémoire vive pour mémoriser provisoirement certaines données. Dans cette mémoire, une première position est prévue pour enregistrer un des dits codes de type.

Des moyens d'inscription, en pratique un élément de logiciel du dit microprocesseur, sont activés à chaque fois qu'une variable à régler a été réglée à l'issue de l'une des dites séquences spécifiques de commandes, pour inscrire dans la dite première position de mémoire le code de type de la variable à régler qui a été réglée. Pour le cas décrit plus haut à l'aide de la figure 2, le code en question est donc celui de la luminance (appelée "lumière" à l'intention de l'utilisateur).

La paire 13 de touches de la télécommande constitue, en plus de sa fonction associée aux menus, un moyen dit "de saisie simplifiée" : lorsqu'aucun menu n'est présent à l'écran, elle réalise le réglage de la variable à régler dont le code est présent dans la première position de mémoire.

Lors de la détection d'une pression sur l'une des touches 13, le microprocesseur va en effet lire le code qui est présent à cet instant dans la position de mémoire, et applique à la variable correspondante un accroissement (si la touche "+" est actionnée) ou une diminution (si la touche "-" est actionnée). La bande 10 du menu 20 de la figure 2 apparaît alors en bas de l'écran pendant une durée limitée.

Les touches 13 servent exclusivement au réglage de la variable dont le code est mémorisé, jusqu'à ce que des menus soient à nouveau appelés pour réaliser un autre réglage.

En pratique, il est avantageux de prévoir au moins deux jeux de touches : un jeu 13 et un jeu 15. Deux modes de fonctionnement sont alors prévus. Le dispositif est muni à cet effet d'une seconde position de mémoire pour enregistrer un des dits codes de type, et les moyens logiciels d'inscription permettent d'inscrire dans la seconde position de mémoire le code de type de la variable en cours de réglage, lorsqu'on le désire à l'issue de l'une des dites séquences de commandes par menus, au moyen par exemple d'une pression sur une touche 16, dite d'affectation. Dans une variante, le déclenchement de l'inscription dans la position de mémoire se fait lorsque les dits moyens de saisie simplifiée sont utilisés, c'est-à-dire que c'est directement l'appui sur une des touches 15 (au lieu de la touche 16) lors d'un réglage par menus, qui déclenche l'inscription du type de variable dans la seconde mémoire. Alors la touche 16 n'est pas utile.

Le jeu de touches 13 permet donc de procéder au réglage qui a été réalisé lors de la dernière séquence de menus, alors que le jeu de touches 15 permet d'enregistrer à volonté un type de réglage et de procéder à nouveau à ce réglage ultérieurement, même lorsque ce réglage n'est pas celui qui a été fait en dernier.

En outre, il est facile de prévoir plusieurs jeux identiques de touches 15, afin que chacun de ces jeux soit à la disposition exclusive d'un utilisateur différent.
On peut en variante prévoir un moyen quelconque (non représenté) d'identification de l'utilisateur, et autant de jeux de premières et secondes positions de mémoire que d'utilisateurs potentiels, un jeu de positions de mémoire différent étant sélectionné selon l'utilisateur. Alors une seule paire de touches 15 est nécessaire.

## Revendications

1. Dispositif de commande pour un appareil audio ou vidéo, muni de moyens de saisie dits normaux permettant de réaliser au choix plusieurs types de réglages différents au moyen de séquences spécifiques de commandes aboutissant chacune au réglage d'une variable à régler déterminée, et muni d'une position de mémoire pour, un code de type étant défini pour chaque variable à régler identifiant de quel type de variable à régler il s'agit, enregistrer un de ces codes de type, et de moyens d'inscription, pour inscrire dans la dite position de mémoire le code de type d'une variable à régler, caractérisé en ce qu'il est muni de moyens pour activer automatiquement les dits moyens d'inscription à chaque fois qu'une variable à régler déterminée est réglée à l'issue de l'une des dites séquences spécifiques de commandes, afin d'inscrire le code de type de la variable qui est réglée, et d'au moins un moyen dit de saisie simplifiée permettant de réaliser, en association avec des moyens d'exécution, le réglage de la variable à régler dont le code est présent dans la dite position de mémoire.

2. Dispositif de commande pour un appareil audio ou vidéo, muni de moyens de saisie dits normaux permettant de réaliser au choix plusieurs types de réglages différents au moyen de séquences spécifiques de commandes aboutissant chacune au réglage d'une variable à régler déterminée, et muni d'une position de mémoire pour, un code de type étant défini pour chaque variable à régler identifiant de quel type de variable à régler il s'agit, enregistrer un de ces codes de type, et de moyens d'inscription, pour inscrire dans la dite position de mémoire le code de type d'une variable à régler, caractérisé en ce qu'il est muni de moyens dits d'affectation permettant de déclencher, lorsqu'on le désire à l'issue de l'une des dites séquences spécifiques de commandes, l'inscription dans la dite position de mémoire du code de type de la variable qui est réglée, et d'au moins un moyen dit de saisie simplifiée, permettant de réaliser en association avec des moyens d'exécution le réglage de la variable à régler dont le code est présent dans la dite position de mémoire.

3. Dispositif de commande selon la revendication 2, caractérisé en ce qu'il est muni de moyens pour déclencher l'inscription dans la position de mémoire lorsque les dits moyens de saisie simplifiée sont utilisés.

4. Dispositif de commande selon l'une quelconque des revendication 1 à 3, caractérisé en ce qu'il comporte plusieurs moyens de saisie simplifiée, et autant de positions de mémoire d'un code de type, dont chacune correspond à un moyen de saisie simplifiée.

5. Dispositif de commande selon la revendication 2, caractérisé en ce qu'il comporte au moins deux moyens de saisie simplifiée avec autant de positions de mémoire d'un code de type, l'un pour lequel les moyens d'inscription sont activés automatiquement à chaque fois qu'une variable à régler déterminée a été réglée à l'issue de l'une des dites séquences spécifiques de commandes, et l'autre pour lequel les dits moyens d'affectation sont prévus, permettant de déclencher lorsqu'on le désire, après qu'une variable à régler déterminée a été réglée à l'issue de l'une des dites séquences spécifiques de commandes, l'inscription en mémoire du code de type de cette variable à régler déterminée.

6. Dispositif de commande selon l'une quelconque des revendications précédentes, caractérisé en ce qu'un moyen de saisie simplifiée comporte une paire de touches de commande, l'une dite "+" et l'autre dite "-", ayant respectivement pour rôle d'augmenter ou de diminuer la valeur de la variable à régler.

7. Dispositif de commande selon l'une quelconque des revendications précédentes, caractérisé en ce qu'il s'agit d'un dispositif de télécommande.

## Patentansprüche

1. Bedienungsvorrichtung für ein Audio- oder Videogerät mit sogenannten normalen Eingabemitteln zur Ermöglichung der wahlweisen Vornahme mehrerer verschiedener Einstellungstypen mittels spezifischer Bedienungssequenzen, die jeweils zum Regeln einer bestimmten zu regelnden Variablen führen, mit einer Speicherposition versehen, um, während für jede zu regelnde Variable ein Typenkode definiert wird, der erkennt, um welchen zu regelnde Variablentyp es sich handelt, einen dieser Typenkodes zu speichern, und mit Schreibmitteln, um den Typenkode einer zu regelnden Variablen in die besagte Speicherposition zu schreiben, dadurch gekennzeichnet, daß sie mit Mitteln versehen ist, um automatisch die besagten Schreibmittel jedesmal dann zu aktivieren, wenn eine bestimmte zu regelnde Variable nach einer der besagten spezifischen Bedienungssequenzen geregelt wird, um den Typenkode der so geregelten Variablen zu schreiben, und zumindest mit einem sogenannten vereinfachten Eingabemittel, das es in Verbindung mit den Ausführungsmitteln ermöglicht, das Regeln der zu regelnden Variablen vorzunehmen, deren Kode sich in der besagten Speicherposition befindet.

2. Bedienungsvorrichtung für ein Audio- oder Videogerät mit sogenannten normalen Eingabemitteln zur Ermöglichung der wahlweisen Vornahme mehrerer verschiedener Einstellungstypen mittels spezifischer Bedienungssequenzen, die jeweils zum Regeln einer bestimmten zu regelnden Variablen führen, mit einer Speicherposition versehen, um, während für jede zu regelnde Variable ein Typenkode definiert wird, der erkennt, um welchen zu regelnde Variablentyp es sich handelt, einen dieser Typenkodes zu speichern, und mit Schreibmitteln, um den Typenkode einer zu regelnden Variablen in die besagte Speicherposition zu schreiben, dadurch gekennzeichnet, daß sie mit sogenannten Zuteilungsmitteln versehen ist, die es ermöglichen, wenn man es wünscht, nach einer der besagten spezifischen Bedienungssequenzen das Schreiben des Typenkodes der geregelten Variablen in die besagte Speicherposition auszulösen, und zumindest mit einem sogenannten vereinfachten Eingabemittel, das es in Verbindung mit den Ausführungsmitteln ermöglicht, das Regeln der zu regelnden Variablen vorzunehmen, deren Kode sich in der besagten Speicherposition befindet.

3. Bedienungsvorrichtung nach Anspruch 2, dadurch gekennzeichnet, daß sie mit Mitteln versehen ist, um das Schreiben in die Speicherposition auszulösen, wenn die besagten vereinfachten Eingabemittel verwendet werden.

4. Bedienungsvorrichtung nach einem beliebigen Anspruch 1 bis 3, dadurch gekennzeichnet, daß sie über mehrere vereinfachte Eingabemittel mit ebenso vielen Speicherpositionen eines Typenkodes verfügt, von denen jede einem vereinfachten Eingabemittel entspricht.

5. Bedienungsvorrichtung nach Anspruch 2, dadurch gekennzeichnet, daß sie mindestens über zwei vereinfachte Eingabemittel mit ebenso vielen Speicherpositionen eines Typencodes verfügt, wobei für den einen die Schreibmittel jedesmal dann automatisch aktiviert werden, wenn eine bestimmte zu regelnde Variable nach einer der besagten spezifischen Bedienungssequenzen geregelt wurde, und für den anderen die besagten Zuteilungsmittel vorgesehen sind, die es ermöglichen, wenn man es wünscht, nachdem eine bestimmte zu regelnde Variable nach einer der besagten spezifischen Bedienungssequenzen geregelt wurde, das Schreiben der Typenkodes dieser bestimmten zu regelnden Variablen in den Speicher auszulösen.

6. Bedienungsvorrichtung nach einem beliebigen der vorhergehenden Ansprüche, dadurch gekennzeichnet, daß ein vereinfachtes Eingabemittel ein Bedienungstastenpaar "+" und "-" enthält, mit der jeweiligen Aufgabe, den zu regelnden Variablenwert zu erhöhen oder zu vermindern.

7. Bedienungsvorrichtung nach einem beliebigen der vorhergehenden Ansprüche, dadurch gekennzeichnet, daß es sich um eine Fernbedienungsvorrichtung handelt.

## Claims

1. A control device for an audio or video apparatus, comprising so called normal acquisition means with which a plurality of different types of settings can be chosen by means of specific control sequences each resulting in the setting of a given variable to be set, and comprising a memory location for registering a type code, such a type code being defined for each variable to be set so as to identify which type of variable to be set is concerned, and writing means for writing the type code of a variable to be set into said memory location, characterized in that the device comprises means for automatically activating said writing means whenever a given variable is set at the end of one of said specific control sequences, so as to write the type code of the variable which has thus been set, and at least a so called easy acquisition means with which the variable whose code is present in said memory location can be set, in association with means for carrying out said setting.

2. A control device for an audio or video apparatus, comprising so called normal acquisition means with which a plurality of different types of settings can be chosen by means of specific control sequences each resulting in the setting of a given variable to be set, and comprising a memory location for registering a type code, such a type code being defined for each variable to be set so as to identify which type of variable to be set is concerned, and writing means for writing the type code of a variable to be set into said memory location, characterized in that the device comprises so called assigning means with which the user can trigger, if desired, at the end of one of said specific control sequences, the writing into said memory location of the type code of the variable which has been set, and at least a so called easy acquisition means with which the variable whose code is present in said memory location can be set in association with means for carrying out said setting.

3. A control device as claimed in Claim 2, characterized in that the device is provided with means for triggering the writing into the memory location when said easy acquisition means are used.

4. A control device as claimed in any one of Claims 1 to 3, characterized in that the device comprises a plurality of easy acquisition means and as many memory locations for a type code, each of which corresponds to an easy acquisition means.

5. A control device as claimed in Claim 2, characterized in that the device comprises at least two easy acquisition means and as many memory locations for a type code, one for which the writing means are automatically activated whenever a given variable has been set at the end of one of said specific control sequences and the other for which said assigning means are provided, with which the writing into the memory location of the type code of said given variable to be set can be triggered, if desired, after said given variable has been set at the end of one of said specific control sequences.

6. A control device as claimed in any one of the preceding Claims, characterized in that a means for easy acquisition comprises a pair of control keys, one "+" and one "-", used for increasing and decreasing the respective value of the variable to be set.

7. A control device as claimed in any one of the preceding Claims, characterized in that the device is a remote-control device.
